# EUROPEAN PATENT SPECIFICATION

(11) **EP 1 826 771 B1**
(45) Date of publication and mention of the grant of the patent: **13.05.2009**
(21) Application number: 06118905.6
(22) Date of filing: 14.08.2006
(51) Int. Cl.: G11C 11/15

(54) **Magnetic memory device using magnetic domain dragging**
Magnetspeichervorrichtung unter Verwendung von Dragging einer magnetischen Domäne
Dispositif de mémoire magnétique utilisant un déplacement de domaine magnétique

(30) Priority: 23.02.2006 KR 20060017876
(43) Date of publication of application: 29.08.2007
(73) Proprietor: Samsung Electronics Co., Ltd., Suwon-si, Gyeonggi-do 442-743 (KR)
(72) Inventor: Lim, Chee-kheng, Samsung Adv. Inst. of Techn., Gyeonggi-do (KR); Kim, Eun-sik, Seoul (KR); Kim, Yong-su, Gangnam-gu, Seoul (KR)
(74) Representative: Greene, Simon Kenneth

(56) References cited:
- EP-A- 1 320 102
- WO-A-20/05069368
- US-A1- 2006 028 863
- US-B1- 6 555 858

## Description

### BACKGROUND OF THE INVENTION

The present invention relates to a magnetic memory device, and more particularly, to a magnetic memory device capable of reading and writing multi-bit data using magnetic domain dragging.

A magnetic random access memory (MRAM) is one kind of non-volatile memory device.

MRAMs include, for example, a transistor, which is a switching device, and a magnetic tunnel junction (MTJ) cell for storing data. Generally, the MTJ cell includes a pinned ferromagnetic layer having a magnetization direction that is pinned, a free ferromagnetic layer having a magnetization direction that can change to be parallel or anti-parallel to the magnetization direction of the pinned ferromagnetic layer, and a non-magnetic layer disposed between the pinned ferromagnetic layer and the free ferromagnetic layer.

However, the data storage capacity of the MRAM is limited since each MTJ cell generally stores only one bit of data. Accordingly, a new storing method is required in order to increase the data storage capacity of magnetic devices such as the MRAM.

An MRAM with multiple domains which can be dragged back and forwards to move a particular domain to a location for reading and writing is described in EP 1320102. The preamble of claim 1 is based on this disclosure.

An MRAM describing trapping of a domain wall by means of domain wall stoppers is described in US 2006/0028863.

### SUMMARY OF THE INVENTION

According to an aspect of the present invention, there is provided a magnetic memory device according to claim 1.

The magnetic domain wall stopper may be a pinning groove formed at the boundary of each sectors.

The each pinning groove may be a pair of pinning grooves formed facing each other at the boundary between each sector.

The sector may be trapezoidal in shape, and the magnetic domain wall stopper may be a boundary line formed by a portion where a short side of one sector and a long side of an adjacent sector meet.

Both ends of the free layer may have a sharp shape.

A length of each sector may be greater than a length of the magnetic domain wall.

The magnetic memory device may include a bit line connected to one end of the free layer and a transistor connected to an other end of the free layer.

The present invention provides a magnetic memory device capable of storing data of a plurality of states by positioning a magnetic domain wall formed at a free layer of the memory device using magnetic domain dragging.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a magnetic memory device according to an embodiment of the present invention;
FIG. 2 is a perspective view of a memory region of FIG. 1 according to an embodiment of the present invention;
FIG. 3 is a series of diagrams illustrating the resistance dependence of the memory region of FIG. 2 on the position of a magnetic domain wall;
FIG. 4A through 4C are diagrams illustrating an operating method of a magnetic memory device according to the present invention;
FIG. 5 is a perspective view of a memory region according to another embodiment of the present invention; and
FIG. 6 is a series of diagrams illustrating the resistance dependence of the memory region of FIG. 5 on the position of a magnetic domain wall.

### DETAILED DESCRIPTION OF THE INVENTION

Now, the present invention will be described more fully with reference to the accompanying drawings, in which exemplary embodiments of the invention are shown.

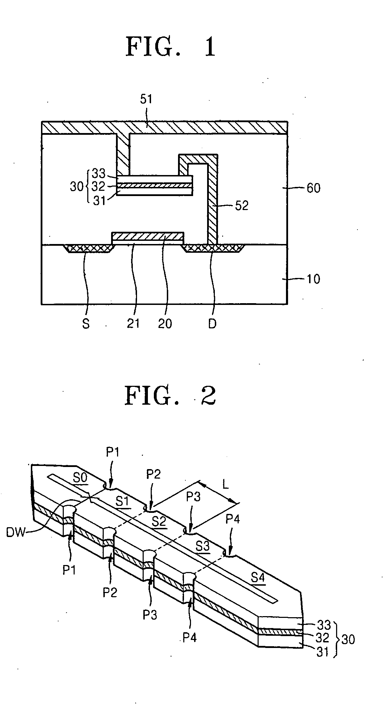

FIG. 1 is a cross-sectional view of a magnetic memory device according to an embodiment of the present invention.

Referring to FIG. 1, a source S and a drain D doped with impurities are formed in a substrate 10, and a gate oxide film 21 and a gate electrode 20 are sequentially stacked on a portion of the substrate 10 that is located between the source S and the drain D. A memory region 30 storing data is formed over the gate electrode 20. An upper portion of the memory region 30 has one end electrically connected to a bit line 51 and the other end electrically connected to the drain D through a conducting line 52.

The memory region 30 may be formed of a giant magnetoresistance (GMR) material. The memory region 30 includes a pinned layer 31 having a magnetization direction that is fixed, a non-magnetic metal layer 32 formed on the pinned layer 31, and a free layer 33 formed on the non-magnetic metal layer 32 and having a magnetization direction that can be switched. The non-magnetic metal layer 32 may be formed of Cu. The free layer 33 includes a plurality of sectors. A magnetic domain wall DW (refer to FIG.2) is formed at the free layer 33. The resistance of the memory region 30 varies depending on the position of the magnetic domain wall DW, and data can be represented using this change of resistance. Reference number 60 indicates an insulating layer.

FIG. 2 is a perspective view of the memory region 30 of FIG. 1 according to an embodiment of the present invention.

Referring to FIG. 2, five sectors S0~S4 are formed in the free layer 33, and pairs of pinning grooves P1~P4 are formed at respective boundaries of the sectors. The sector S0 is connected to the bit line 51, and the sector S4 is electrically connected to the drain D. Two magnetic domains are formed facing each other at the free layer 33, and one magnetic domain wall DW is formed between the magnetic domains. The magnetic domain wall DW can be variably positioned at a magnetic domain wall stopper.

The magnetic domain wall stopper includes pairs of pinning grooves P1~P4 according to an embodiment of the present invention.

The magnetic domain wall DW may be positioned at each of the pinning grooves P1, P2, P3, and P4, and each position of the magnetic domain wall DW represents one piece of information. A magnetic domain having one magnetization direction is formed at the pinned layer 31.

When a pulse current smaller than a predetermined critical current is applied to one end of the free layer 33, the magnetic domain wall DW is not moved but remains in a position located between one of the pairs of pinning grooves. On the other hand, when a pulse current greater than the critical current is applied to the free layer 33, the magnetic domain wall DW is moved from between one pair of pinning grooves where the magnetic domain wall DW has been located prior to the application of the current and stops between a pair of adjacent pinning groove. At this point, the direction in which the magnetic domain wall DW moves is determined by the direction of the pulse current. The critical current may be determined by the shape of the pinning groove.

Ends of the sectors S0 and S4 are tapered to a point in order to prevent other magnetic domain walls DW from being formed at the sectors S0 and S4.

A length of the magnetic domain wall DW varies depending on the magnetic material used to form the free layer 33 and approximately ranges from 30 to 80 nm. A length L, which is the minimum length of each sector, should be longer than the length of the magnetic domain wall DW.

Each of the pinning grooves is formed as a pair, but the present invention is not limited to this. For example, each magnetic domain wall stopper may be formed of one pinning groove.

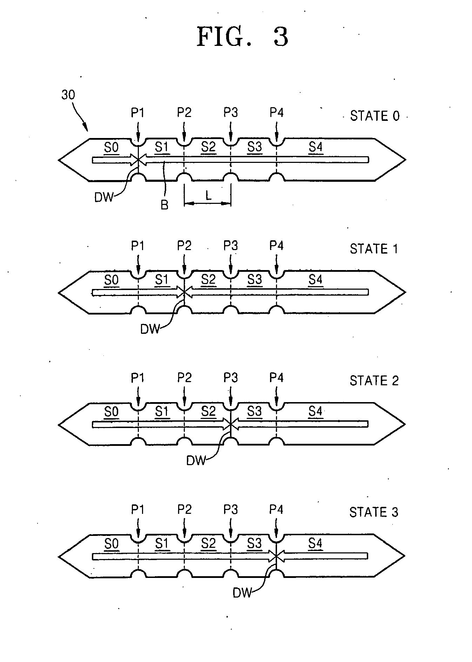

FIG. 3 is a series of diagrams illustrating the resistance dependence of the memory region 30 of FIG. 2 on the position of the magnetic domain wall DW position.

Referring to FIG. 3, in each of the STATEs 0-3, the magnetic domain wall DW is positioned between one of the pairs of pinning grooves P1~P4 of the free layer 33. Referring to STATE 0 of FIG. 3, when the magnetization direction of the pinned layer 31 corresponding to the sectors S1~S3 is in a direction indicated by an arrow B, the magnetization direction of the free layer 33 contained in the memory region 30 is parallel to the magnetization direction of pinned layer 31, and therefore the resistance of the memory region 30 is at a minimum.

In STATE 1, the magnetic domain wall DW is positioned between the pair of pinning grooves P2, the magnetization direction of the free layer 33 is divided into the sector S1 which is anti-parallel to the magnetization direction of the pinned layer 31 and the sectors S2 and S3 which are parallel to the magnetization direction of the pinned layer 31.

As the memory region 30 changes from STATE 1 to STATE 2 and STATE 3, the magnetic domain wall DW moves to the right of FIG. 3. Accordingly, the region having a magnetization direction anti-parallel to the magnetization direction of the free layer 33 becomes longer, which increases the resistance of the memory region 30.

Since the resistance of the memory region 30 changes depending on the position of the magnetic domain wall DW, determining which STATEs 0-3 the memory region 30 is in can be achieved by measuring the amount of current flowing through the memory region 30. Therefore, an information storage device can be realized by writing and reading the STATEs 0-3 in the memory region 30.

A method of operating the magnetic memory device according to the present invention will now be described with reference to the accompanying drawings.

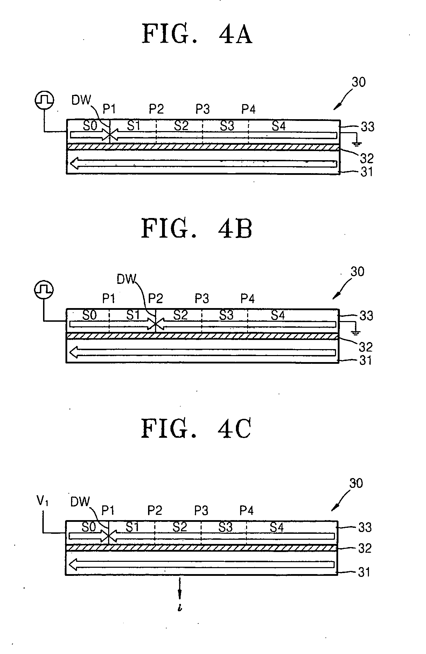

FIG. 4A through 4C are views illustrating an operating method of a magnetic memory device according to the present invention. Referring to FIG. 4A, the magnetic domain wall DW is initially positioned at the pinning groove P1 in the memory region 30. Resistance of the memory region 30 is at a minimum because the magnetization direction of the sectors S1~S3 is parallel to the magnetization direction of the pinned layer 31.

Next, when a positive pulse current higher than a critical current (magnetic drain dragging pulse current) that can overcome the pinning groove P1 is applied to an input end of the free layer 33, the magnetic domain wall DW moves to the right of the figure, as illustrated in FIG. 4B. Duration of the pulse current ranges from approximately 0.2 to 1.0 ns. The duration may vary depending on the length of the sector. The critical current may vary depending on the shape of the pinning groove.

Meanwhile, when a negative pulse current higher than the critical current is applied to the input end of the free layer 33, the magnetic domain wall DW moves to the left of the figure. In this way, the magnetic domain wall DW can be moved by applying a positive or negative pulse current to the input end of the free layer 33, and this process corresponds to an information writing process.

Referring to FIG. 1, the information writing process can address one memory region 30 by applying a positive current higher than the critical current to the bit line 51 connected to the input end of the free layer 33 and applying a voltage higher than a threshold voltage at the gate electrode 20 of a transistor. The bit line 51 serves as an input part inputting a dragging signal used for magnetic domain dragging.

Next, a method of reading information stored in the memory region 30 will be described. Referring FIG. 4C, a predetermined voltage is applied to the input end of the free layer 33, and then current flowing through the memory region 30 is measured. Since resistance of the memory region 30 can be calculated from the measured current, information represented by the memory region 30 can be read using the current measured.

Referring to FIG. 1, the information reading addresses one memory region 30 by applying a voltage to the bit line 51 and the gate electrode 20. Also, a current flowing through the memory region 30 can be measured by a sensing part (not shown) connected to the source electrode S. The sensing point may be an amperemeter.

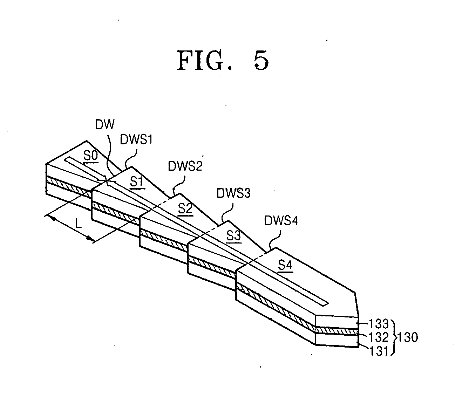

FIG. 5 is a perspective view of the memory region 130 according to another embodiment of the present invention.

Referring to FIG. 5, sectors S0~S4 are formed at a free layer 133, and magnetic domain wall stoppers DWS1~DWS4 are formed between the sectors. The sectors S0~S3 are trapezoidal in shape, and have short parallel sides and long parallel sides. A portion where the short side of the sector (for example, S1) contact the long side of the other sector (for example, S2) corresponds to a magnetic domain wall stopper (for example, DWS2).

The sector S0 is connected to the line 51 (refer FIG.1), and the sector S4 is electrically connected to the drain D (refer to FIG.1). Two magnetic domains are formed facing each other at the free layer 133, and thus a magnetic domain wall DW is formed. When the magnetic domain wall DW is respectively positioned at the magnetic domain wall stoppers DWS1, DWS2, DWS3, and DWS4, they each represent one piece of information. A magnetic domain having a fixed magnetization direction is formed in a region corresponding to the sectors at a pined layer 131.

When a pulse current smaller than a predetermined critical current is applied to an input end of the free layer 133, the magnetic domain wall DW cannot pass through the stopper and thus does not move. On the other hand, when a pulse current higher than the critical current is applied to the input end of the free layer 133, the magnetic domain wall DW can pass through the stopper and stops at the adjacent stopper. Since a region of the long side has a higher energy than that of the short side in the sector, the magnetic domain wall DW that has entered other sector moves by itself toward the stopper position, which is the position of the short side having a lower energy.

The length of the magnetic domain wall DW varies depending on the magnetic material used to form the free layer 33, and ranges from approximately 30 to 80 nm. A length L, which is the length of each sector, should be longer than the length of the magnetic domain wall DW.

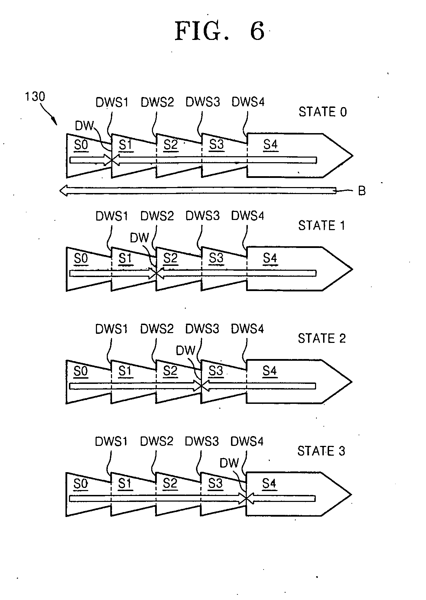

FIG. 6 is a series of diagrams illustrating a resistance dependence of the memory region 130 on the position of a magnetic domain wall DW.

Referring to FIG. 6, in STATEs 0-3, the magnetic domain wall DW is positioned at one of the magnetic domain wall stoppers DWS1~DWS4 at the free layer 133. When the magnetization direction of the pinned layer 131 corresponding to the sectors S0~S4 is in a direction indicated by an arrow B, most magnetization directions of the free layer 133 in the memory region 130 for STATE 0 are parallel to the pinned layer 131, and therefore the resistance of the memory region 130 is at a minimum.

In STATE 1, the domain wall DW is positioned at the magnetic domain wall stopper DWS2, and the magnetization direction of the sector S1 of the free layer 133 becomes anti-parallel to the magnetization direction of the pinned layer 131. Accordingly, the resistance of the memory region in STATE 1 is larger than the resistance of the memory region in STATE 0.

As the memory region 130 changes from STATE 1 to STATE 2 and STATE 3, the magnetic domain wall DW moves to the right of FIG. 6. Accordingly, the region having a magnetization direction anti-parallel to the magnetization direction of the free layer 133 becomes longer, which increases the resistance of the memory region 130.

Since the resistance of the memory region 130 depends on the position of the magnetic domain wall DW, determining which STATEs 0-3 the memory region 130 is in can be achieved by measuring the amount of current flowing through the memory region 130 due to an applied voltage. Therefore, an information storage apparatus can be realized by writing and reading the STATES 0-3 in the memory region 130.

Since the method of writing information on the memory region and reading the information according to the embodiment illustrated in FIGS. 2 through 4 is substantially the same as the method according to the embodiment illustrated in FIGS. 5 and 6, detailed descriptions thereof will be omitted.

As described above, the magnetic memory device using magnetic domain dragging according to the present invention can be used to store a number of pieces of information (data), the number being the same as the number of magnetic drain wall stoppers formed in a memory region.

Therefore, the magnetic memory device according to the present invention can increase the capacity of data storage. Accordingly, the magnetic device such as the MRAM having an increased data storage capacity can be realized by applying the present invention.

## Claims

1. A magnetic memory device using magnetic domain dragging, the magnetic memory device comprising:
a memory region (30, 130) comprising:
a free layer (33, 133) having adjoined sectors with a magnetic domain wall (DW) at least one boundary of said sectors;
a pinned layer (31, 131) having a fixed magnetization direction; and
a non-magnetic layer (32, 132) formed between the free layer and the pinned layer,
an input part (51) electrically connected to an end of the free layer to input a dragging signal for magnetic domain dragging; and
a sensing part for measuring a current flowing through the memory region;
**characterised in that** the pinned layer extends along the adjoined sectors of the free layer;
a magnetic domain wall stopper for stopping the magnetic domain wall is formed at each boundary between the sectors; and
the position of the domain wall determines the state of the memory.

2. The magnetic memory device of claim 1, wherein the magnetic domain wall stopper (P1, P2, P3, P4) is a pinning groove formed at the boundary between each sector.

3. The magnetic memory device of claim 2, wherein each pinning groove (P1, P2, P3, P4) is a pair of pinning grooves formed facing each other at the boundary between each sector.

4. The magnetic memory device of any preceding claim, wherein the sectors have a trapezoidal shape, and the magnetic domain wall stoppers (P1, P2, P3, P4) are boundary lines formed by a portion where a short side of one sector and a long side of an adjacent sector meet.

5. The magnetic memory device of any preceding claim, wherein both ends of the free layer (33, 133) have a sharp shape.

6. The magnetic memory device of any preceding claim, wherein a length of each sector is greater than a length of the magnetic domain wall.

7. The magnetic memory device of any preceding claim, further comprising:
a bit line (51) connected to an end of the free layer; and
a transistor connected to an other end of the free layer.

8. The magnetic memory device of claim 7, wherein the input part is the bit line (51) and the sensing part is an amperemeter connected to the transistor.

9. The magnetic memory device of any preceding claim, wherein the non-magnetic layer (32, 132) is formed of metal.

10. The magnetic memory device of any preceding claim, wherein the non-magnetic layer (32, 132) is formed of Cu.

## Patentansprüche

1. Magnetspeichervorrichtung, die Magnetic-Domain-Dragging verwendet, umfassend:
einen Speicherbereich (30, 130), umfassend:
eine freie Schicht (33, 133), die aneinander grenzende Sektoren mit einer magnetischen Domänenwand (DW) an mindestens einer Grenze der Sektoren aufweist,
eine gepinnte Schicht (31, 131) mit einer festgelegten Magnetisierungsrichtung und
eine nichtmagnetische Schicht (32, 132), die zwischen der freien Schicht und der gepinnten Schicht ausgebildet ist,
einen Eingangsteil (51), der mit einem Ende der freien Schicht verbunden ist, um ein Draggingsignal für das Magnetic-Domain-Dragging einzugeben, und
einen Abtastteil zum Messen eines Stroms, der durch den Speicherbereich fließt,
**dadurch gekennzeichnet, dass** die gepinnte Schicht sich entlang der aneinander grenzenden Sektoren der freien Schicht erstreckt,
ein Stopper der magnetischen Domänenwand zum Stoppen der magnetischen Domänenwand an jeder Grenze zwischen den Sektoren ausgebildet ist und
die Position der Domänenwand den Zustand des Speichers bestimmt.

2. Magnetspeichervorrichtung nach Anspruch 1, wobei der Stopper (P1, P2, P3, P4) der magnetischen Domänenwand eine Pinningvertiefung ist, die an der Grenze zwischen jedem Sektor ausgebildet ist.

3. Magnetspeichervorrichtung nach Anspruch 2, wobei jede Pinningvertiefung (P1, P2, P3, P4) ein Paar von Pinningvertiefungen darstellt, die so ausgebildet sind, dass sie an der Grenze zwischen jedem Sektor einander zugewandt sind.

4. Magnetspeichervorrichtung nach einem der vorhergehenden Ansprüche, wobei die Sektoren eine Trapezform aufweisen und die Stopper (P1, P2, P3, P4) der magnetischen Domänenwand Grenzlinien sind, die durch einen Abschnitt gebildet sind, an dem eine kurze Seite eines Sektors und eine lange Seite eines benachbarten Sektors zusammentreffen.

5. Magnetspeichervorrichtung nach einem der vorhergehenden Ansprüche, wobei beide Enden der freien Schicht (33, 133) eine spitze Form aufweisen.

6. Magnetspeichervorrichtung nach einem der vorhergehenden Ansprüche, wobei eine Länge jedes Sektors größer ist als eine Länge der magnetischen Domänenwand.

7. Magnetspeichervorrichtung nach einem der vorhergehenden Ansprüche, weiter umfassend:
eine Bitleitung (51), die mit einem Ende der freien Schicht verbunden ist, und
einen Transistor, der mit einem anderen Ende der freien Schicht verbunden ist.

8. Magnetspeichervorrichtung nach Anspruch 7, wobei der Eingangsteil die Bitleitung (51) ist und der Abtastteil ein Amperemeter ist, das mit dem Transistor verbunden ist.

9. Magnetspeichervorrichtung nach einem der vorhergehenden Ansprüche, wobei die nichtmagnetische Schicht (32, 132) aus Metall gebildet ist.

10. Magnetspeichervorrichtung nach einem der vorhergehenden Ansprüche, wobei die nichtmagnetische Schicht (32, 132) aus Cu gebildet ist.

## Revendications

1. Dispositif de mémoire magnétique utilisant un déplacement de domaine magnétique, le dispositif de mémoire magnétique comprenant :
une zone de mémoire (30, 130) comprenant :
une couche libre (33, 133) ayant des secteurs contigus avec une paroi de domaine magnétique (DW) à au moins une limite desdits secteurs ;
une couche fixée (31, 131) ayant une direction de magnétisation fixe ; et
une couche non magnétique (32, 132) formée entre la couche libre et la couche fixée,
une partie d'entrée (51) connectée électriquement à une extrémité de la couche libre pour faire entrer un signal de déplacement pour le déplacement du domaine magnétique ; et
une partie de détection pour mesurer un courant circulant dans la zone de mémoire ;
**caractérisé en ce que** la couche fixée est disposée le long des secteurs contigus de la couche libre ;
un dispositif d'arrêt de paroi de domaine magnétique pour arrêter la paroi de domaine magnétique est formé à chaque limite entre les secteurs ; et
la position de la paroi de domaine détermine l'état de la mémoire.

2. Le dispositif de mémoire magnétique selon la revendication 1, dans lequel le dispositif d'arrêt de paroi de domaine magnétique (P1, P2, P3, P4) est une rainure de fixation formée à la limite entre chaque secteur.

3. Dispositif de mémoire magnétique selon la revendication 2, dans lequel chaque rainure de fixation (P1, P2, P3, P4) est une paire de rainures de fixation formées de sorte qu'elles se font face à la limite entre chaque secteur.

4. Dispositif de mémoire magnétique selon l'une quelconque des revendications précédentes, dans lequel les secteurs ont une forme trapézoïdale, et les dispositifs d'arrêt de paroi de domaine magnétique (P1, P2, P3, P4) sont des lignes de délimitation formées par une partie où un côté court d'un secteur et un côté long d'un secteur contigu se rencontrent.

5. Dispositif de mémoire magnétique selon l'une quelconque des revendications précédentes, dans lequel les deux extrémités de la couche libre (33, 133) ont une forme aiguë.

6. Dispositif de mémoire magnétique selon l'une quelconque des revendications précédentes, dans lequel une longueur de chaque secteur est supérieure à une longueur de la paroi de domaine magnétique.

7. Dispositif de mémoire magnétique selon l'une quelconque des revendications précédentes, comprenant en outre :
une ligne de binaire (51) connectée à une extrémité de la couche libre ; et
un transistor connecté à une autre extrémité de la couche libre.

8. Dispositif de mémoire magnétique selon la revendication 7, dans lequel la partie d'entrée est la ligne de binaire (51) et la partie de détection est un ampèremètre connecté au transistor.

9. Dispositif de mémoire magnétique selon l'une quelconque des revendications précédentes, dans lequel la couche non magnétique (32, 132) est constituée de métal.

10. Dispositif de mémoire magnétique selon l'une quelconque des revendications précédentes, dans lequel la couche non magnétique (32, 132) est constituée de Cu.
